# EUROPÄISCHE PATENTSCHRIFT

(11) **EP 1 186 682 B1**
(45) Veröffentlichungstag und Bekanntmachung des Hinweises auf die Patenterteilung: **10.11.2010**
(21) Anmeldenummer: 01121080.4
(22) Anmeldetag: 03.09.2001
(51) Int. Cl.: C23C 14/35, H01J 37/34, C23C 14/34, B22D 19/16

(54) **Zylinderförmiges Sputtertarget und Verfahren zu seiner Herstellung**
Cylindrical sputtering target and process for its manufacture
Cible de pulvérisation cylindrique et procédé pour sa fabrication

(30) Priorität: 05.09.2000 DE 10043748
(43) Veröffentlichungstag der Anmeldung: 13.03.2002
(73) Patentinhaber: W.C. Heraeus GmbH, 63450 Hanau (DE)
(72) Erfinder: Schlott, Martin, Dr., 63075 Offenbach (DE); Heindel, Josef, 63512 Hainburg (DE); Luh, Helmut, 63457 Hanau (DE); Wollenberg, Norbert, 63538 Grosskrotzenburg (DE)
(74) Vertreter: Kühn, Hans-Christian

(56) Entgegenhaltungen:
- EP-A- 0 500 031
- US-A- 5 171 411
- PATENT ABSTRACTS OF JAPAN vol. 013, no. 187 (C-592), 2. Mai 1989 (1989-05-02) & JP 01 011968 A (SEIKO EPSON CORP), 17. Januar 1989 (1989-01-17)
- PATENT ABSTRACTS OF JAPAN vol. 012, no. 191 (C-501), 3. Juni 1988 (1988-06-03) & JP 62 297464 A (SEIKO EPSON CORP), 24. Dezember 1987 (1987-12-24)
- PATENT ABSTRACTS OF JAPAN vol. 015, no. 027 (C-0797), 22. Januar 1991 (1991-01-22) & JP 02 267261 A (KOUJIYUNDO KAGAKU KENKYUSHO:KK), 1. November 1990 (1990-11-01)

## Beschreibung

Die vorliegende Erfindung betrifft ein Verfahren zur Herstellung eines zylinderförmigen Sputtertargets für insbesondere den Einsatz als rotierende Sputterkathode.

Zylinderförmige Sputtertargets, sogenannte Zylinder-Magnetrons, werden insbesondere im Bereich der Großflächenbeschichtung eingesetzt, wobei das Targetmaterial zerstäubt wird und auf dem zu beschichtenden Bauteil abgeschieden wird.

Zur Herstellung von zylinderförmigen Sputtertargets besteht einerseits die Möglichkeit das Targetmaterial direkt als Zylinder auszuformen oder andererseits auf einem zylinderförmigen Trägerrohr anzuordnen. Diese unterschiedlichen Gestaltungsmöglichkeiten werden stark durch die Eigenschaften des Targetmaterials, wie z.B. Verarbeitbarkeit, beeinflußt. So werden Werkstoffe, wenn sie entweder zu spröde, wie z. B. Silizium, oder zu duktil sind, wie z.B. Zinn, üblicherweise auf einem Trägerrohr angeordnet.

Das Aufbringen des Targetmaterials auf das Trägerrohr erfolgt nach dem Stand der Technik durch thermisches Spritzen oder durch Auflöten des zylinderförmigen Targetmaterials auf ein Trägerrohr.

Beim thermischen Spritzen wird das Targetmaterial als Draht oder in Pulverform einer Flamme oder Plasma zugeführt, durch die das Targetmaterial aufschmilzt. Zugleich wird das aufgeschmolzene Targetmaterial auf das Trägerrohr aufgespritzt. Dies führt dazu, dass das Targetmaterial nach dem Aufspritzen eine große Porosität und einen großen Sauerstoffgehalt aufweist, was für die nachträgliche Benutzung des Sputtertargets für Beschichtungszwecke nachteilig ist. Außerdem wird beim thermischen Spritzen ein erheblicher Teil des Materials am Trägerrohr vorbeigespritzt, was zu einem entsprechenden Materialverlust führt.

Das andere bekannte Herstellungsverfahren besteht darin, die Sputtertargets in Zylinderform in einer entsprechenden Kokille zu gießen und diese Zylinder anschließend über einen Lötprozeß auf einem Trägerrohr zu befestigen. Dies erfordert jedoch eine Nachbearbeitung der gegossenen Zylinder und ist aufgrund des Lötprozesses insgesamt sehr zeit- und kostenintensiv. Darüber hinaus besteht bei den üblicherweise verwendeten Zylinderlängen von ca. 3 - 4 Metern die Gefahr, dass der sehr lange Spalt zwischen Trägerrohr und Targetmaterial, der mit Lot gefüllt werden muss, nicht gleichmäßig mit Lot gefüllt werden kann, so dass eine fehlerhafte Lötverbindung entsteht, die beim Sputtern wegen unzureichender Wärmeabfuhr zum Aufschmelzen des Targets führen kann. EP-A-0 500 031 offenbart ein Verfahren zur Herstellung eines zylindrischen Sputtertargets durch Gießen. Dabei wird ein mit Targetmaterial zu beschichtendes Trägerrohr in einer Gussform angeordnet und das geschmolzene Targetmaterial in diese Gussform eingefüllt.

Es ist deshalb Aufgabe der vorliegenden Erfindung ein einfaches, zeit- und kostengünstiges Verfahren zur Herstellung von zylinderförmigen Sputtertargets bereitzustellen, das darüber hinaus auch den Anforderungen hinsichtlich der Qualität des Sputtertargets für die damit durchzuführenden Beschichtungen gerecht wird. Entsprechend sollen auch einfach herstellbare und qualitativ hochwertige zylinderförmige Sputtertargets bereitgestellt werden.

Diese Aufgabe wird gelöst durch ein Verfahren nach Anspruch 1. Vorteilhafte Ausgestaltungen sind Gegenstand der Unteransprüche.

Wesentlich ist bei der vorliegenden Erfindung, dass das Targetmaterial direkt auf das zylinderförmige Trägerrohr und hier insbesondere auf die gegebenenfalls benetzte oder geeignet hierzu behandelte Hauptzylinderfläche des Trägerrohrs aufgegossen wird, wobei eine Gußform verwendet wird, in die das Trägerrohr eingesetzt wird. Auf diese Weise ist es möglich ohne zusätzliche aufwendige Verbindungstechniken eine gute und sichere Verbindung des Targetmaterials mit dem Trägerrohr herzustellen, wobei eine sehr gute und kompakte Targetmaterialqualität insbesondere hinsichtlich Porenfreiheit und Gefügestruktur erzielt wird. Durch das direkte Erstarren des Targetmaterials auf dem Trägerrohr kann ein feinkörniges und fehlerfreies zylinderförmiges Target erhalten werden, welches durch Benetzung bzw. Adhäsion zwischen Targetmaterial und Trägerrohrmaterial und/oder eine mechanische Umklammerung des Trägerrohrs durch das Targetmaterial einen stabilen Verbund aus Trägerrohr und Targetmaterial ergibt.

Die zuerst genannte Art der Verbindung zwischen Targetmaterial und Trägerrohr wird bei der vorliegenden Erfindung darüber hinaus Weise dadurch intensiviert, dass vor dem Aufgießen des Targetmaterials auf das Trägerrohr das zylinderförmige Trägerrohr mit einer Oberflächenbeschichtung auf der Zylinderhauptfläche versehen wird, die eine benetzbare Schicht umfasst, welches bezüglich des Targetmaterials einen höheren Schmelzpunkt aufweist, so dass bei dem anschließenden Aufgießen des Targetmaterials ein Aufschmelzen der benetzbaren Schicht vermieden wird. Die benetzbare Schicht, welche vorzugsweise aus Kupfer, Silber, Gold, Nickel und deren Legierungen gebildet, führt dazu, dass die Benetzung des Trägerrohrs durch die Schmelze erleichtert wird, was zu einer besseren Verbindung zwischen Targetmaterial und Trägerrohr führt.

Eine andere vorteilhafte Möglichkeit, die Verbindung zwischen Targetmaterial und Trägerrohr zu verbessern, besteht darin, das Trägerrohrmaterial, das aus unmagnetischem Werkstoff, nämlich rostfreien Stählen besteht, so auf das Targetmaterial abzustimmen, dass der thermische Ausdehnungskoeffizient des Trägerrohrs kleiner ist als der des Targetmaterials. Dadurch ergibt sich bei der Abkühlung des fertiggegossenen zylinderförmigen Sputtertargets eine stärkere Schrumpfung des Targetmaterials im Vergleich mit dem Trägerrohr, was zu einer elastischen Verspannung und einer starken mechanischen Umklammerung des Trägerrohrs durch das Targetmaterial führt.

Das erfindungsgemäße Verfahren eignet sich in besonderer Weise für niedrig schmelzende Metalle oder Legierungen, da bei diesen Werkstoffen nur ein geringer Schmelzaufwand erforderlich ist und auch das Erstarrungsverhalten der Schmelze leicht kontrollierbar ist. Obwohl deshalb Metalle und Legierungen mit einer Schmelztemperatur von unter 420° C, nämlich Zinn, erfindungsgemäß sind, ist das erfindungsgemäße Verfahren gleichwohl auch für Targetmaterialien mit höheren Schmelzpunkten einsetzbar.

Ferner ergibt sich bei einem feinkörnigen Gußgefüge mit insbesondere einer Korngröße ≤ 10 mm ein besonders gutes Sputter-Verhalten, so dass ein derartiges Gefüge bevorzugt ist. Dies kann beispielsweise dadurch erreicht werden, dass die Erstarrung durch eine entsprechende Abkühlung oder das Zusetzen von Dotierungen zur Schmelze gesteuert wird. Die Dotierungen bewirken ebenso wie eine starke Unterkühlung der Schmelze eine verstärkte Keimbildung beim Erstarren der Schmelze und führen so zu einem feinkörnigen Gefüge. Hier hat es sich als vorteilhaft erwiesen Dotierungen einer Konzentration von 200 -10 000 ppm der Schmelze zuzusetzen.

Wird Zinn als Targetmaterial verwendet, so hat sich hier als Dotierung Kupfer bewährt, da Kupfer bis zu einer Konzentration von bis zu 1% keine negativen Auswirkungen auf die Verwendung des Sputtertargets als Beschichtungsquelle hat.

Beim erfindungsgemäßen Verfahren zur Herstellung eines zylindrischen Sputtertargets mit dem obengenannten Merkmal hat es sich als besonders vorteilhaft erwiesen eine zylindrische Gußform zu verwenden, bei der das Trägerrohr, auf das das Targetmaterial aufgegossen werden soll, als innere Formwand verwendet wird, während die eigentliche zylindrische Gußform die äußere Formwand sowie den Boden der Gußform bereitstellt. Die Schmelze wird hierbei in den Zwischenraum zwischen dem Trägerrohr als der inneren Formwand und der Außenwand der Gußform eingefüllt, so dass nach dem Abkühlen und dem Erstarren des Targetmaterials das Trägerrohr mit dem aufgegossenen Targetmaterial als fertiges zylinderförmiges Sputtertarget aus der Gußform entnommen werden kann.

Die Befüllung der Gußform kann dabei sowohl in der Form des fallenden Füllens als auch des steigenden Füllens erfolgen. Das steigende Füllen hat dabei den Vorteil, dass die Schmelze weniger mit Sauerstoff belastet wird und sich kaum Oxide bilden. Dazu kann beispielsweise an der Gußform ein Trichter vorgesehen werden, der über einen Speiser mit der Unterseite der Gußform bzw. dem Boden der Gußform verbunden ist, so dass nach dem Einfüllen der Schmelze in den Trichter die Schmelze über den Speiser in die Gußform gelangt und in dieser von unten nach oben aufsteigt.

Wie bereits oben angeführt, ist für die Erstarrung der Schmelze, d.h. des Targetmaterials, insbesondere die Temperaturführung wichtig. Deshalb ist es vorteilhaft, zum einen die Gußform vor dem Einfüllen der Schmelze vorzuheizen, als auch die Gußform nach dem Einfüllen der Schmelze zu kühlen.

Um ein geregeltes Erstarren des Targetmaterials vom Trägerrohr ausgehend von innen nach außen zu erzielen, welches den Vorteil hat, dass eine gute Umklammerung auf dem Trägerrohr und ein weitgehend porenfreies Gefüge erzielt wird, ist erfindungsgemäß das überwiegende Abführen der Erstarrungswärme über das Trägerrohr vorgesehen. Dies kann beispielsweise dadurch erreicht werden, dass durch das Trägerrohr bzw. in dem Trägerrohr angeordnete Kühlleitungen entsprechende Kühlmedien geführt werden, die entweder gasförmig oder flüssig sind. Weiterhin kann es, um eine günstige Spannungsverteilung über die Länge des zylinderföhnigen Targetmaterials zu erzielen, auch vorteilhaft sein, die Erstarrungsfront zusätzlich zur Erstarrung von innen nach außen, oder alternativ dazu, von einem Ende des Trägerrohrs zum anderen verlaufen zu lassen. Auch dies kann durch eine entsprechende Führung von Kühlmedien erreicht werden.

Weitere Vorteile, Kennzeichnung und Merkmale der vorliegenden Erfindung werden anhand der nachfolgenden, detaillierten Beschreibung der Ausführungsbeispiele deutlich, die in den beigefügten Zeichnungen rein schematisch dargestellt sind. Dabei zeigt
- Fig. 1: eine perspektivische Ansicht einer ersten Ausführungsform eines zylinderförmigen Sputtertargets;
- Fig. 2: eine perspektivische Ansicht einer zweiten Ausführungsform eines zylinderförmigen Sputtertargets;
- Fig. 3: eine perspektivische Ansicht einer Gießvorrichtung zur Herstellung eines erfindungsge- mäßen Sputtertargets.

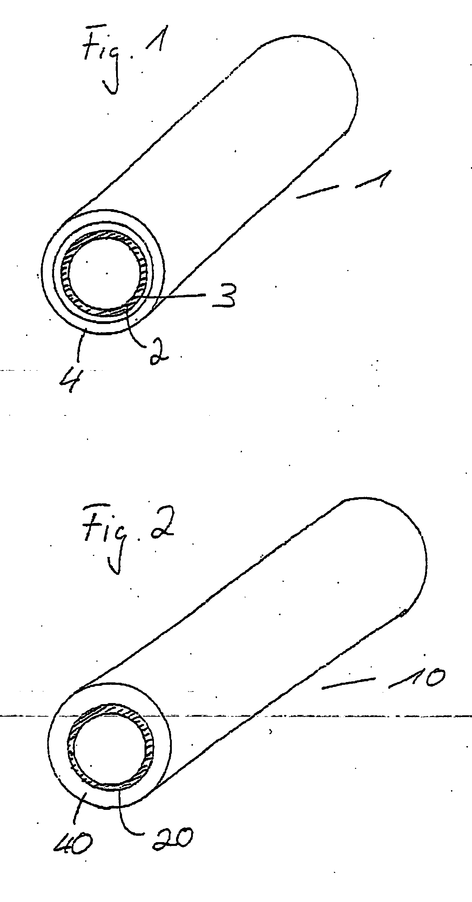

Fig. 1 zeigt in einer perspektivischen Darstellung ein erfindungsgemäßes, zylinderförmiges Sputtertarget 1, welches aus einem innenliegenden Trägerrohr 2, einer Trägerrohrbeschichtung 3 und dem die Zylinderhauptfläche des Trägerrohrs bedeckende Targetmaterial 4 aufgebaut ist.

Die zweite Ausführungsform eines zylinderförmigen Sputtertargets 10, das entsprechend der Darstellung in Fig. 1 in gleicher Weise in Fig. 2 dargestellt ist, umfaßt ein Trägerrohr 20 und ein dieses umgebendes Targetmaterial 40, wobei hier im Unterschied zur ersten Ausführungsform das Trägerrohr 20 keine Trägerrohrbeschichtung aufweist.

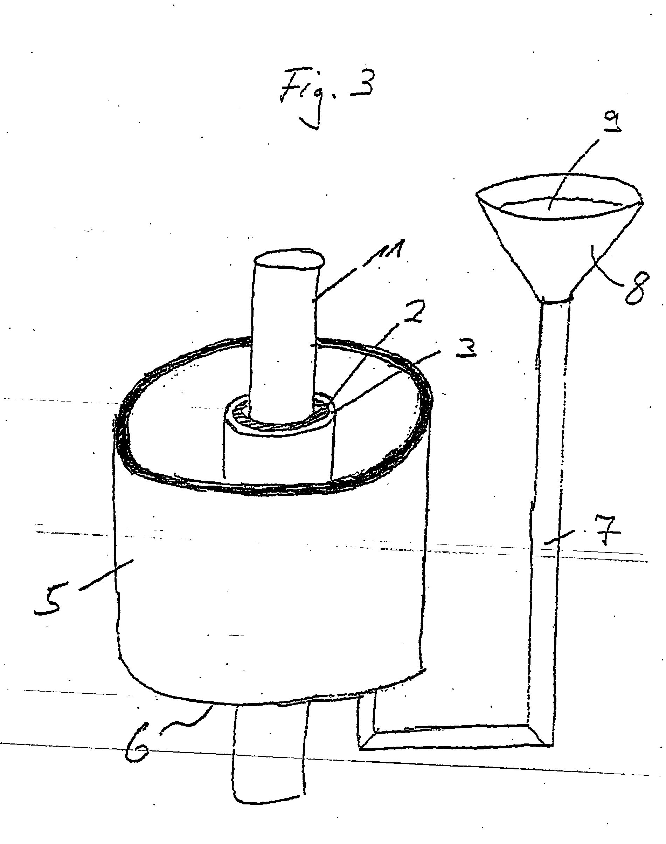

Fig. 3 zeigt eine Gießvorrichtung, mit der die erfindungsgemäßen Sputtertargets hergestellt werden können. Die Gießvorrichtung umfaßt eine zylindrische Gießform 5 mit einem Boden 6, in die koaxial das zu beschichtende Trägerrohr 2 als Innenrohr der Gußform eingesetzt werden kann. Im gezeigten Beispiel weist das Trägerrohr 2 entsprechend dem Ausführungsbeispiel der Fig. 1 eine Trägerrohrbeschichtung 3 auf, welche die Benetzung des Trägerrohrs 2 mit der Schmelze 9 günstig beeinflusst.

Durch den Zwischenraum zwischen Trägerrohr 2 und der Außenwand der Gußform 5 wird der Raum definiert, in den die Schmelze 9 eingegossen werden kann und der nach der Erstarrung der Schmelze 9 vom Targetmaterial 4 eingenommen werden soll. Das Einfüllen der Schmelze 9 des Targetmaterials 4 erfolgt üblicherweise über einen Trichter 8, der auch als Vorratsbehälter für die Schmelze dient, damit ausreichend Schmelze nachfließen kann, wenn bei der Erstarrung der Schmelze 9 durch die Schrumpfung entsprechender Raum frei wird. Der Trichter 8 wird üblicherweise oberhalb der Gußform 5 angeordnet, so dass die Schmelze allein durch die Schwerkraft in die Gießform einfließt. Üblicherweise wird dazu der Trichter über einen Speiser 7 direkt mit der Oberseite der Gußform 5 verbunden, so dass die Schmelze von oben in die Gußform 5 einfließt. Allerdings kann, bei einer bevorzugten Ausführungsform, wie sie in Fig. 3 dargestellt ist, der Speiser 7 auch so angeordnet sein, dass er den Trichter 8 mit der Unterseite 6 der *Gußform 5* verbindet, so dass die Schmelze 9 in der Gießform 5 von unten nach oben ansteigt. Dies hat insbesondere den Vorteil, dass eine geringere Oxidation der Schmelze mit entsprechender Oxidbildung stattfindet.

Um die Erstarrung der Schmelze 9 in der Gußform 5 steuern zu können, ist bei der gezeigten Ausführungsform koaxial zum Trägerrohr 2 zum Beispiel eine Kühlmittelleitung 11 vorgesehen, die es ermöglicht, Kühlmittel durch das Trägerrohr 2 und somit entlang der Innenwand der Gußform 5 zu führen. Auf diese Weise kann insbesondere eine Erstarrung der Schmelze 9 von innen nach außen bewirkt werden.

Zusätzlich kann bei einer weiteren bevorzugten Ausführungsform, die hier nicht gezeigt ist, eine das Kühlmittel in sich umwälzende Kühlmittelleitung 11 vorgesehen sein, die an einem Ende geschlossen ist, so dass durch fortschreitendes Absenken der Kühlmittelleitung 11 in das Trägerrohr 2 auch eine Erstarrung von einem Ende des Trägerrohrs 2 zum anderen Ende eingestellt werden kann.

## Patentansprüche

1. Verfahren zur Herstellung eines zylindrischen Sputtertargets, welches umfasst:
- Bereitstellung einer Gussform (5), in die ein mit Targetmaterial zu beschichtendes Trägerrohr (2) eingesetzt wird
- Aufschmelzen des Targetmaterials
- Einfüllen des geschmolzenen Targetmaterials (9) in die Gussform (5), so dass das Trägerrohr (2) in dem Targetmaterial eingegossen wird
- Abkühlen und Erstarren des Targetmaterials (4),
wobei das Trägerrohr (2) vor dem Einsetzen in die Gussform (5) mit einer benetzbaren Beschichtung versehen wird, welche bezüglich des Targetmaterials einen höheren Schmelzpunkt aufweist, wobei als Material für das Trägerrohr (2) rostfreier Stahl und für das Targetmaterial (4) Zinn verwendet wird, und wobei beim Erstarren die Erstarrungswärme durch Kühlung des Trägerrohrs (2) über gasförmige oder flüssige Kühlmedien gesteuert überwiegend über das Trägerrohr (2) abgeführt wird, so dass die Erstarrung der Schmelze (9) von innen nach außen erfolgt.

2. Verfahren nach Anspruch 1, **dadurch gekennzeichnet, dass** das zu beschichtende Trägerrohr (2) in einer zylindrischen Gussform (5) als innere Formwand koaxial zu einer äußeren Formwand der Gussform (5) angeordnet wird und die Schmelze (9) zwischen innerer Formwand und äußerer Formwand eingefüllt wird.

3. Verfahren nach Anspruch 1 oder 2, **dadurch gekennzeichnet, dass** die aus der Gussform (5) und Trägerrohr (2) gebildete Form vor dem Einfüllen der Schmelze (9) vorgeheizt wird.

4. Verfahren nach einem der Ansprüche 1 bis 3, **dadurch gekennzeichnet, dass** der Schmelze (9) Dotierungen zugesetzt werden.

5. Verfahren nach einem der Ansprüche 1 bis 4, **dadurch gekennzeichnet, dass** durch die Einstellung der Gussformtemperatur und/oder die Bereitstellung der Menge und/oder die Temperatur der Kühlmedien der Erstarrungsvorgang so geführt wird, dass ein feinkörniges Gefüge des Targetmaterials (4) mit Korngrößen ≤ 10 mm gebildet wird.

6. Verfahren nach Anspruch 4, **dadurch gekennzeichnet, dass** die Dotierung mit Kupfer erfolgt.

## Claims

1. Method for the manufacture of a cylindrical sputter target which comprises:
- provision of a mould (5) into which a carrier tube (2) is inserted which is to be coated with target material,
- founding the target material,
- filling the molten target material (9) into the mould (5) so that the carrier tube (2) is bedded into the target material,
- cooling and solidifying the target material (4),
wherein the carrier tube (2) is provided, prior to insertion into the mould (5), with a wettable coating which has a higher melting point relative to the target material, wherein stainless steel is used as the material for the carrier tube (2) and tin for the target material (4), and wherein the solidification heat, controlled during solidification by cooling the carrier tube (2) via gaseous or liquid cooling mediums, is predominantly removed via the carrier tube (2) so that the melt (9) solidifies from the inside to the outside.

2. Method according to claim 1, **characterized in that** the carrier tube (2) to be coated is arranged in a cylindrical mould (5) as inner mould wall coaxially to an outer mould wall of the mould (5), and the melt (9) is filled in between inner mould wall and outer mould wall.

3. Method according to claim 1 or 2, **characterized in that** the shape formed of the mould (5) and carrier tube (2) is preheated prior to filling in the melt.

4. Method according to any one of the claims 1 to 3, **characterized in that** dopings are added to the melt (9).

5. Method according to any one of the claims 1 to 4, **characterized in that** the solidification process is operated such - by adjustment of the mould temperature and/or the provision of the quantity and/or the temperature of the cooling mediums - that a fine-grained structure of the target material (4) is formed with grain sizes ≤ 10 mm.

6. Method according to claim 4, **characterized in that** doping is done with copper.

## Revendications

1. Procédé pour la fabrication d'une cible de pulvérisation cylindrique, qui comprend :
- la préparation d'un moule de fonte (5) dans lequel un tuyau de support (2) devant être revêtu de matière cible est inséré,
- la fonte de la matière cible,
- le remplissage de la matière cible fondue (9) dans le moule de fonte (5), de sorte que le tuyau de support (2) est coulé dans la matière cible,
- le refroidissement et la solidification de la matière cible (4),
dans lequel le tuyau de support (2) est pourvu d'un revêtement pouvant être mouillé avant l'insertion dans le moule de fonte (5), lequel revêtement présente un point de fusion supérieur par rapport à la matière cible, dans lequel de l'acier inoxydable est utilisé comme matériau pour le tuyau de support (2) et de l'étain est utilisé pour la matière cible (4), et dans lequel la chaleur de solidification lors de la solidification est évacuée par refroidissement du tuyau de support (2) par le biais de milieux de refroidissement gazeux ou liquides de manière contrôlée principalement par le tuyau de support (2), de sorte que la solidification de la masse fondue (9) s'effectue de l'intérieur vers l'extérieur.

2. Procédé selon la revendication 1, **caractérisé en ce que** le tuyau de support (2) devant être revêtu est disposé dans un moule de fonte cylindrique (5) en tant que paroi de moule interne de manière coaxiale à une paroi de moule externe du moule de fonte (5) et la masse fondue (9) est versée entre la paroi de moule interne et la paroi de moule externe.

3. Procédé selon la revendication 1 ou 2, **caractérisé en ce que** le moule formé par le moule de fonte (5) et le tuyau de support (2) est préchauffé avant le remplissage de la masse fondue (9).

4. Procédé selon l'une quelconque des revendications 1 à 3, **caractérisé en ce que** des dopages sont ajoutés à la masse fondue (9).

5. Procédé selon l'une quelconque des revendications 1 à 4, **caractérisé en ce que** le réglage de la température du moule de fonte et/ou la préparation de la quantité et/ou la température des milieux de refroidissement du processus de solidification est mené de sorte qu'une structure à grain fin de la matière cible (4) est formée avec des tailles de grain ≤ 10 mm.

6. Procédé selon la revendication 4, **caractérisé en ce que** le dopage s'effectue avec du cuivre.
